# EUROPÄISCHE PATENTANMELDUNG

(11) **EP 4 657 341 A1**
(43) Veröffentlichungstag der Anmeldung: **03.12.2025**
(21) Anmeldenummer: 24178526.0
(22) Anmeldetag: 28.05.2024
(51) Int. Cl.: G06Q 10/04, G06Q 50/04, G05B 19/418

(54) **OPTIMIERUNG EINER PRODUKTION**

(71) Anmelder: Siemens Aktiengesellschaft, 80333 München (DE)
(72) Erfinder: Klein, Wolfram, 85579 Neubiberg (DE); Kubo, Florian, 97727 Fuchsstadt (DE); Wehrstedt, Jan Christoph, 81829 München (DE)
(74) Vertreter: Siemens Patent Attorneys

(57) **Zusammenfassung**

Die Erfindung betrifft eine Vorrichtung (100) zur Optimierung einer Produktion eines Produkts, insbesondere zur Optimierung eines Werkereinsatzes bei der Produktion, umfassend:
• eine erste Schnittstelle (101), die derart ein gerichtet ist, einen Produktionsparametersatz für die Produktion einzulesen,
• eine zweite Schnittstelle (102), die derart eingerichtet ist, ein trainiertes Machine-Learning-Modell einzulesen,
- wobei das Machine-Learning-Modell mittels Simulationsdaten darauf trainiert ist, in Abhängigkeit eines vorgegebenen Produktionsparametersatzes eine Kennzahl und eine Reihenfolge von Produktionsschritten auszugeben,
- wobei die Simulationsdaten durch eine Vielzahl von computergestützten Materialflusssimulationen auf Basis eines computergestützten Materialflussmodells der Produktion erfasst werden, wobei für jede computergestützte Materialflusssimulation modifizierte Produktionsparametersätze (Beschreibung: div. Schwankungen, andere Abarbeitungsregeln, etc...) angewandt werden, und anhand jeder ausgeführten Materialflusssimulation eine Kennzahl und eine Reihenfolge der Produktionsschritte ermittelt wird,

• ein Optimierungsmodul (103), das derart eingerichtet ist, für den eingelesenen Produktionsparametersatz eine Kennzahl mittels des trainierten Machine-Learning-Modells zu bestimmen, und den eingelesenen Produktionsparametersatz derart zu modifizieren, dass die Kennzahl optimiert wird, und für den derart modifizierten Parametersatz eine entsprechende Reihenfolge der Produktionsschritte mittels des trainierten Machine-Learning-Modells zu ermitteln,
und
• ein Ausgabemodul (104), das derart eingerichtet ist, den derart optimierten Produktionsparametersatz und die entsprechende Reihenfolge der Produktionsschritte auszugeben.

## Beschreibung

Die Erfindung betrifft eine Vorrichtung und ein computerimplementiertes Verfahren zur Optimierung einer Produktion eines Produkts, insbesondere zur Optimierung eines Werkereinsatzes bei der Produktion, sowie ein Computerprogrammprodukt.

Um eine Produktion eines Produkts flexibel zu gestalten, können heutzutage sogenannte "Operator Guidance Systeme" (dt. Werkerführungssysteme) verwendet werden. Mit diesen können den verfügbaren Mitarbeitern/Werkern entsprechend ihren Fähigkeiten und basierend auf einem vorgegebenen Zeitplan geeignete Tätigkeiten zugewiesen werden. Dadurch wird der Mitarbeitereinsatz aufgabenspezifisch verteilt. Je nach Arbeitsweise können die Mitarbeiter aus einer vom Operator Guidance System vorgeschlagenen Liste an Aufgaben eine passende auswählen und diese abarbeiten. Je nach System kann die Liste ein oder mehrere Elemente umfassen und ggf. eine Priorisierung aufweisen. In der Regel wird dem Operator Guidance System ein Produktionsplan übergeben, der Informationen über die Aufgaben der jeweiligen Mitarbeiter und ggf. eine Reihenfolge umfasst. Oft kann es allerdings bei der Abarbeitung des Produktionsplans zu Abweichungen kommen. Ein Operator Guidance System kann deshalb über einen regelbasierten Ansatz verfügen, welcher die Abarbeitung des Produktionsplans überwacht und bei Bedarf korrigierend eingreift, wie z.B. eine Priorität von Operationen anpasst. Die zugrundeliegenden Regeln sind typischerweise vorab festgelegt und oft nicht optimal an die Produktionsbedingungen angepasst.

Es ist daher eine Aufgabe der vorliegenden Erfindung, einen Produktionsprozess zu verbessern.

Die Aufgabe wird durch die in den unabhängigen Ansprüchen beschriebenen Maßnahmen gelöst. In den abhängigen Ansprüchen sind vorteilhafte Weiterbildungen der Erfindung dargestellt.

Gemäß einem ersten Aspekt betrifft die Erfindung eine Vorrichtung zur Optimierung einer Produktion eines Produkts, umfassend:
- eine erste Schnittstelle, die derart ein gerichtet ist, einen Produktionsparametersatz für die Produktion einzulesen,
- eine zweite Schnittstelle, die derart eingerichtet ist, ein trainiertes Machine-Learning-Modell einzulesen,
   ∘ wobei das Machine-Learning-Modell mittels Simulationsdaten darauf trainiert ist, in Abhängigkeit eines vorgegebenen Produktionsparametersatzes eine Kennzahl und eine Reihenfolge von Produktionsschritten auszugeben,
   ∘ wobei die Simulationsdaten durch eine Vielzahl von computergestützten Materialflusssimulationen auf Basis eines computergestützten Materialflussmodells der Produktion erfasst werden, wobei für jede computergestützte Materialflusssimulation modifizierte Produktionsparametersätze angewandt werden, und anhand jeder ausgeführten Materialflusssimulation eine Kennzahl und eine Reihenfolge der Produktionsschritte ermittelt wird,
- ein Optimierungsmodul, das derart eingerichtet ist, für den eingelesenen Produktionsparametersatz eine Kennzahl mittels des trainierten Machine-Learning-Modells zu bestimmen, und den eingelesenen Produktionsparametersatz derart zu modifizieren, dass die Kennzahl optimiert wird, und für den derart modifizierten Produktionsparametersatz eine entsprechende Reihenfolge der Produktionsschritte mittels des trainierten Machine-Learning-Modells zu ermitteln,
   und
- ein Ausgabemodul, das derart eingerichtet ist, den derart optimierten Produktionsparametersatz und die entsprechende Reihenfolge der Produktionsschritte auszugeben.

Die Vorrichtung kann als Operator Guidance System realisiert oder mit einem solchen verbunden werden. Die Vorrichtung kann insbesondere zur Optimierung eines Werkereinsatzes bei der Produktion eingerichtet sein.

Es ist ein Vorteil der vorliegenden Erfindung, dass mittels eines Digitalen Zwillings, nämlich einer Materialflusssimulation der Produktion, die Verteilung der Produktionsvorgänge auf die Werker/Mitarbeiter und/oder Maschinen gelernt und optimiert werden kann.

Eine Priorisierung der Bearbeitung von Arbeitsschritten unterliegt somit keinem festen Regelwerk, sondern unter Verwendung des digitalen Zwillings und eines lernenden Systems können geeignete Produktionsparameter bestimmt werden.

Produktionsparameter können hierbei insbesondere angeben, welches Produkt produziert wird, welche Produktionsschritte in welcher Reihenfolge nötig sind, eine Dauer von Produktionsschritten, welche Konfigurationen der Maschinen, wie viele Mitarbeiter zu einer bestimmten Zeit mit bestimmten Fähigkeiten zur Verfügung stehen, welche Randbedingungen bei der Produktion vorliegen etc. Produktionsparameter umfassen vorzugsweise einen Produktionsplan. Außerdem können Produktionsparameter Regeln zur Abarbeitung der Produktionsschritte umfassen.

In einer Ausführungsform kann die Vorrichtung einen Simulator umfassen, der derart eingerichtet ist,
- eine Vielzahl von computergestützten Materialflusssimulationen auf Basis eines computergestützten Materialflussmodells auszuführen, wobei für jede computergestützte Materialflusssimulation modifizierte Produktionsparametersätze angewandt werden,
- anhand jeder ausgeführten Materialflusssimulation eine Kennzahl und eine Reihenfolge der Produktionsschritte zu ermitteln,
   und
- für jede Materialflusssimulation die Reihenfolge und die Kennzahl als Simulationsdaten sowie den entsprechenden modifizierten Produktionsparametersatz auszugeben.

Somit können eine Vielzahl von unterschiedlichen Produktionsszenarien betrachtet und ausgewertet werden.

In einer Ausführungsform kann die Vorrichtung ein Trainingsmodul umfassen, das derart eingerichtet ist, das Machine-Learning-Modell mittels der Simulationsdaten derart zu trainieren, in Abhängigkeit eines vorgegebenen Produktionsparametersatzes eine jeweils zugeordnete Kennzahl und Reihenfolge der Produktionsschritte zu reproduzieren.

Ein Machine-Learning-Modell kann beispielsweise ein neuronales Netz sein. Es kann auch ein Reinforcement-Learning-Ansatz genutzt werden. Das trainierte Machine-Learning-Modell ermöglicht, auf einfach Weise eine Kennzahl und eine Reihenfolge der Produktionsschritte zu ermitteln.

In einer Ausführungsform kann das Trainingsmodul weiter eingerichtet sein, zusätzlich zu den Simulationsdaten Betriebsdaten der Produktion für das Training des Machine-Learning-Modells zu berücksichtigen.

Dies erweitert den Datenraum für das Training des Machine-Learning-Modells und somit dessen Genauigkeit.

In einer Ausführungsform kann die Kennzahl
- einen Durchsatz der Produktion entsprechend der Produktionsparameter,
- eine zeitliche Dauer mindestens eines Produktionsschrittes,
   und/oder
- gebundenes Kapital betreffen.

Eine Kennzahl kann beispielsweise als ein Key-Performance-Indicator (KPI) bezeichnet werden. Insbesondere können auch mehr als eine Kennzahl für einen Produktionsparametersatz bestimmt werden.

In einer Ausführungsform kann das computergestützte Materialflussmodell
- Arbeitsplätze und Verfügbarkeitsinformationen der Mitarbeiter der Produktion,
- räumliche Abstände zwischen Maschinen und/oder Material,
- Produktionsschritte der Produktion,
   und/oder
- eine Aufteilung der Produktionsschritte auf Maschinen und/oder Mitarbeiter umfassen.

Mit dem computergestützten Materialflussmodell kann somit ein Produktionsablauf simuliert werden.

In einer Ausführungsform kann ein Produktionsparametersatz eine Regel zur Abarbeitung der Produktionsschritte umfassen.

In einer Ausführungsform kann Ausgabemodul weiter eingerichtet sein, auf Basis des optimierten Produktionsparametersatzes eine individuelle Reihenfolge von Produktionsschritten für einen Mitarbeiter auszugeben.

Beispielsweise kann die Vorrichtung derart ausgestaltet sein, dass eine individuelle Zuweisung an einzelne Mitarbeiter über eine jeweilige Schnittstelle möglich ist.

Gemäß einem zweiten Aspekt betrifft die Erfindung ein computerimplementiertes Verfahren zur Optimierung einer Produktion eines Produkts, mit den Verfahrensschritten:
- Einlesen eines Produktionsparametersatzes für die Produktion,
- Einlesen eines trainierten Machine-Learning-Modells,
   ∘ wobei das Machine-Learning-Modell mittels Simulationsdaten darauf trainiert ist, in Abhängigkeit eines vorgegebenen Produktionsparametersatzes eine Kennzahl und eine Reihenfolge von Produktionsschritten auszugeben,
   ∘ wobei die Simulationsdaten durch eine Vielzahl von computergestützten Materialflusssimulationen auf Basis eines computergestützten Materialflussmodells der Produktion erfasst werden, wobei für jede computergestützte Materialflusssimulation modifizierte Produktionsparametersätze angewandt werden, und anhand jeder ausgeführten Materialflusssimulation eine Kennzahl und eine durchgeführte Reihenfolge der Produktionsschritte ermittelt wird,
- Bestimmen einer Kennzahl mittels des trainierten Machine-Learning-Modells für den eingelesenen Produktionsparametersatz,
- Modifizieren des eingelesenen Produktionsparametersatzes derart, dass die Kennzahl optimiert wird, und Ermitteln einer entsprechenden Reihenfolge der Produktionsschritte für den derart modifizierten Produktionsparametersatz mittels des trainierten Machine-Learning-Modells,
   und
- Ausgeben des derart optimierten Produktionsparametersatzes und der entsprechenden Reihenfolge der Produktionsschritte.

Des Weiteren betrifft die Erfindung ein Computerprogrammprodukt, das direkt in einen programmierbaren Computer ladbar ist, umfassend Programmcodeteile, die bei der Ausführung des Programms durch einen Computer diesen veranlassen, die Schritte eines erfindungsgemäßen Verfahrens auszuführen.

Ein Computerprogrammprodukt kann beispielsweise auf einem Speichermedium, wie z.B. Speicherkarte, USB-Stick, CD-ROM, DVD, ein nichtflüchtiger/dauerhaftes Speichermedium (engl. Non-transitory storage Medium) oder auch in Form einer herunterladbaren Datei von einem Server in einem Netzwerk bereitgestellt oder geliefert werden.

Ausführungsbeispiele der erfindungsgemäßen Vorrichtung und des erfindungsgemäßen Verfahrens sind in den Zeichnungen beispielhaft dargestellt und werden anhand der nachfolgenden Beschreibung näher erläutert. Es zeigen:
- Fig. 1:: zeigt ein Ausführungsbeispiel einer erfindungsgemäßen Vorrichtung zur Optimierung einer Produktion eines Produkts; und
- Fig. 2:: zeigt ein Ausführungsbeispiel eines erfindungsgemäßen computerimplementierten Verfahrens zur Optimierung einer Produktion eines Produkts.

Einander entsprechende Teile sind in allen Figuren mit den gleichen Bezugszeichen versehen.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis des/der Verfahrensanspruchs/Verfahrensansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

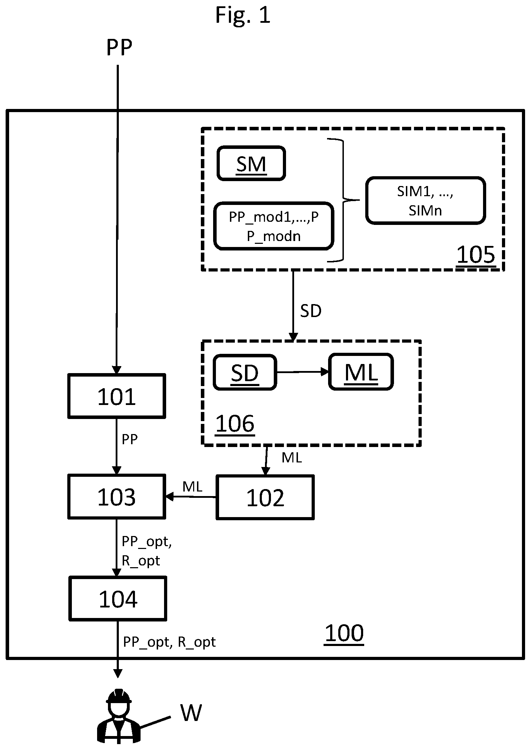

Figur 1 zeigt ein erstes Ausführungsbeispiel einer erfindungsgemäßen Vorrichtung 100 zur Optimierung einer Produktion mindestens eines Produkts/einer Vielzahl von Produkten. Die Vorrichtung 100 ist insbesondere geeignet, einen Produktionsprozess über einen vorgegebenen Zeitraum, wie z.B. einen Tag oder eine Woche, zu optimieren, indem optimierte Produktionsparameter bestimmt und an Mitarbeiter zur Abarbeitung übergeben werden. Somit ist die Vorrichtung 100 insbesondere für eine Optimierung eines Werkereinsatzes/Mitarbeitereinsatzes in der Produktion durchzuführen.

Die Vorrichtung 100 umfasst eine erste Schnittstelle 101, eine zweite Schnittstelle 102, ein Optimierungsmodul 103 und ein Ausgabemodul 104. Die Vorrichtung 100 kann außerdem mindestens einen Prozessor umfassen. Des Weiteren kann die Vorrichtung 100 einen Simulator 105 und/oder ein Trainingsmodul 106 umfassen. Die Vorrichtung 100 kann beispielsweise als ein Operator Guidance System eingerichtet sein. Die Vorrichtung 100 kann insbesondere sowohl Software- als auch Hardwarekomponenten umfassen.

Die erste Schnittstelle 101 ist derart eingerichtet, einen Produktionsparametersatz PP für die Produktion einzulesen. Der Produktionsparametersatz umfasst mindestens einen Parameter für die Produktion, wie z.B. eine vorgegebene Reihenfolge der Produktionsschritte.

Der Produktionsparametersatz umfasst außerdem insbesondere mindestens eine Regel zur Abarbeitung von Produktionsschritten der Produktion. Beispielsweise ist der Produktionsparametersatz PP produktspezifisch konfiguriert und umfasst die relevanten Produktionsschritte sowie Regeln für deren Abarbeitung, Konfigurationen der Maschinen, Dauer von Produktionsschritten, Informationen über Mitarbeiter und weitere Randbedingungen der Produktion, wie z.B. Fertigstellungsdatum.

Die zweite Schnittstelle 102 ist derart eingerichtet ein trainiertes Machine-Learning-Modell ML einzulesen. Das trainierte Machine-Learning-Modell ML wurde vorzugsweise vorab mittels Simulationsdaten aus dem Simulator 105 im Trainingsmodul 106 trainiert. Das Machine-Learning-Modell ML wurde darauf trainiert, in Abhängigkeit eines vorgegebenen Produktionsparametersatzes eine Kennzahl für diesen Produktionsparametersatz und eine Reihenfolge von Produktionsschritten auszugeben. Das Training erfolgt mittels Simulationsdaten SD. Die Simulationsdaten SD werden vom Simulator 105 bereitgestellt.

Der Simulator 105 ist derart eingerichtet, eine Vielzahl von computergestützten Materialflusssimulationen SIM1, ..., SIMn auf Basis eines vorgegebenen computergestützten Materialflussmodells SM der Produktion auszuführen. Das computergestützte Materialflussmodell SM ist vorzugsweise an die jeweilige Produktion angepasst und wird bereitgestellt.

Das computergestützte Materialflussmodell SM umfasst Arbeitsplätze und Verfügbarkeitsinformation der Mitarbeiter der Produktion, räumliche Abstände zwischen Maschinen und/oder Material, Produktionsschritte der Produktion,
und/oder eine Aufteilung der Produktionsschritte auf Maschinen und/oder Mitarbeiter umfasst. Beispielsweise kann das computergestützte Materialflussmodell SM alle Arbeitsplätze sowie Mitarbeiter umfassen, wobei die Arbeitsplätz so modelliert werden, dass wenn für Maschinen mehrere aufeinanderfolgende Bearbeitungsschritte benötigt werden, diese getrennt ausgeführt werden. Wenn beispielsweise beim Erwärmen eines Produktes im Ofen eine Bestückung des Ofens mit gebundenem Mitarbeiter stattfindet, erfolgt der Erwärmungsprozess ohne Mitarbeiter und ein Entnahmevorgang wiederum mit Mitarbeiter. Ebenso bildet das computergestützte Materialflussmodell SM Wege ab, die die Mitarbeiter laufen müssen, um von einem Arbeitsplatz zum nächsten zu gelangen und/oder um Material und/oder Maschinen zu holen und wieder zurückzubringen. Die Produktionsschritte (BoP) und die Aufteilung auf die Maschinen liegen entweder bereits im Auftragsnetz vor, oder können produktspezifisch hinterlegt sein.

Jede computergestützte Materialflusssimulation SIM1, ..., SIMn basiert auf einem anderen modifizierten Produktionsparametersatz PP_mod1,..., PP_modn. Insbesondere basieren die jeweiligen modifizierten Produktionsparametersätze PP_mod1,..., PP_modn auf dem eingelesenen Produktionsparametersatz PP und unterscheiden sich untereinander. Beispielsweise wird der eingelesene Produktionsparametersatz PP jeweils derart modifiziert, wie z.B. Änderung einer Abarbeitungsregel und/oder Berücksichtigung einer Schwankung einer Bearbeitungsdauer, dass eine Vielzahl von verschiedenen modifizierten Produktionsparametersätze PP_mod1,..., PP_modn zur Verfügung steht. Anschließend kann für jeden modifizierten Produktionsparametersätze PP_mod1,..., PP_modn eine computergestützte Materialflusssimulation durchgeführt werden, wobei ein jeweiliger modifizierter Produktionsparametersatz PP_mod1,..., PP_modn als Parameter für das computergestützte Materialflussmodell SM genutzt werden.

Anhand jeder ausgeführten Materialflusssimulation SIM1, ..., SIMn wird für jeden modifizierter Produktionsparametersatz PP_mod1,..., PP_modn eine Kennzahl und eine Reihenfolge der Produktionsschritte ermittelt. Eine Kennzahl kann einen Durchsatz der Produktion entsprechend der jeweiligen (modifizierten) Produktionsparameter, eine zeitliche Dauer mindestens eines Produktionsschrittes, und/oder gebundenes Kapital betreffen. Beispielsweise können somit produktionsrelevante KPIs berechnet werden, wie z.B. Durchsatz, Termintreue, gebundenes Kapital (gefüllter Buffer), etc.

Es werden die verschiedenen modifizierten Produktionsparametersätze PP_mod1,..., PP_modn ausgehend von den eingelesenen Produktionsparametern PP bereitgestellt. Die modifizierten Produktionsparametersätze PP_mod1 können beispielsweise folgende verschiedene Szenarien durch Regeln abbilden:
- In einer Variante kann beispielsweise immer ein Produktionsschritt mit dem frühesten Fertigstellungdatum, für welches Bearbeitungskapazitäten bestehen, benutzt werden. Bei Gleichstand wird ein Produktionsschritt zufällig ausgewählt.
- Es kann immer ein Produktionsschritt mit dem frühesten Fertigstellungdatum, für den die größte Kapazität beim nachfolgenden Produktionsschritt erzielt wird, benutzt werden. Bei Gleichstand wird ein Produktionsschritt zufällig ausgewählt.
- Es wird immer ein Produktionsschritt mit dem frühesten Fertigstellungdatum benutzt; bei Gleichstand zufällig. Ein Produktionsschritt wird immer mit demselben Material gewählt wie das Material bei einem vorhergehenden Schritt.
- Es wird streng nach dem vorgegebenen Produktionsplan gearbeitet.
- Es können Produktionsstationen priorisiert werden, wobei vorzugsweise nach einem frühesten Fertigstellungsdatum gearbeitet wird. Zusätzlich können an weniger priorisierten Stationen die dort laufenden Produktionsschritte für hoch priorisierte Tätigkeiten/Produktionsschritte unterbrochen werden.
- Es können zusätzlich zu den oben genannten Szenarien jeweils das früheste Fertigstellungsdatum und ein darauffolgender Tag gleich gewichtet werden.
- Für einen bestimmten Mitarbeiter werden abwechselnd und/oder in einem definierten Rhythmus Produktionsschritte vorgegeben, um beispielsweise eine körperliche Belastung des Mitarbeiters gering zu halten. Hierbei können insbesondere Produktionsschritte derart gewählt werden, die unterschiedlich arbeitsintensiv und/oder stark repetitiv sind. Außerdem können Laufzeiten bzw. Entfernungen zwischen Produktionsstationen berücksichtigt werden.
- Es ist auch möglich, dass Aufträge, die an derselben Produktionsstation gefertigt werden und/oder dieselben Maschinen verwenden, zusammen gefertigt werden.
- Außerdem können unterschiedliche Schichtmodelle und/oder Zuweisung von Mitarbeitern auf bestimmte Produktionsschritte, Maschinenausfallzeiten und/oder personelle Ausfälle berücksichtigt werden.

Jeweils können modifizierte Produktionsparameter bereitgestellt werden. Auf diese Weise werden für die Produktion eine Vielzahl von unterschiedlichen Szenarien durchgespielt, wobei sich jeweils eine bestimmte Reihenfolge der Produktionsschritte ergibt. Für jedes Szenario wird eine Kennzahl ermittelt.

Anschließend wird für jede durchgeführte Materialflusssimulation die Reihenfolge der Produktionsschritte und die Kennzahl als Simulationsdaten SD sowie der entsprechende modifizierte Produktionsparametersatz ausgegeben.

Folglich umfassen die Simulationsdaten SD einen modifizierten Produktionsparametersatz, eine zugehörige Reihenfolge von Produktionsschritten und eine entsprechende Kennzahl.

Die Simulationsdaten SD werden dem Trainingsmodul 106 übergeben. Das Trainingsmodul 106 ist derart eingerichtet das Machine-Learning-Modell ML mittels der Simulationsdaten SD derart zu trainieren, dass in Abhängigkeit eines vorgegebenen Produktionsparametersatzes eine jeweils zugeordnete Kennzahl und Reihenfolge der Produktionsschritte reproduziert wird. Das Machine-Learning-Modell ML kann beispielsweise ein künstliches neuronales Netz sein.

Alternativ kann ein Reinforcement-Learning-Ansatz genutzt werden. Dabei können zusätzlich Betriebsdaten der Produktion für das Training genutzt werden.

Das trainierte Machine-Learning-Modell ML wird dem Optimierungsmodul 103 bereitgestellt.

Das Optimierungsmodul 103 ist derart eingerichtet, für den eingelesenen Produktionsparametersatz PP eine entsprechende Kennzahl mittels des trainierten Machine-Learning-Modells zu bestimmen, und den eingelesenen Produktionsparametersatz derart zu modifizieren, dass die Kennzahl optimiert wird, und für den derart modifizierten Produktionsparametersatz eine entsprechende Reihenfolge der Produktionsschritte mittels des trainierten Machine-Learning-Modells zu ermitteln. Beispielsweise kann das Optimierungsmodul 103 aus den Simulationsdaten einen modifizierten Produktionsparametersatz selektieren, dem eine optimierte Kennzahl zugeordnet ist. Somit wird beispielsweise der ursprünglich eingelesene Produktionsparametersatz PP modifiziert, indem beispielsweise eine Abarbeitungsregel geändert wird, so dass beispielsweise ein höherer Durchsatz erzielt werden kann.

Für den optimierten Produktionsparametersatz PP_opt wird die Reihenfolge R_opt der Produktionsschritte mittels des Machine-Learning-Modells ML ermittelt.

Das Ausgabemodul 104 ist derart eingerichtet den optimierten Produktionsparametersatz PP_opt und die entsprechende Reihenfolge R_opt der Produktionsschritte auszugeben.

Die Vorrichtung 100 kann insbesondere als ein Operator Guidance System ausgestaltet sein. Somit kann das Ausgabemodul 104 mit individuellen (mobilen) Empfangsgeräten jeweiliger Mitarbeiter W gekoppelt sein und auf Basis des optimierten Produktionsparametersatzes eine individuelle Reihenfolge von Produktionsschritten an einen jeweiligen Mitarbeiter W ausgeben.

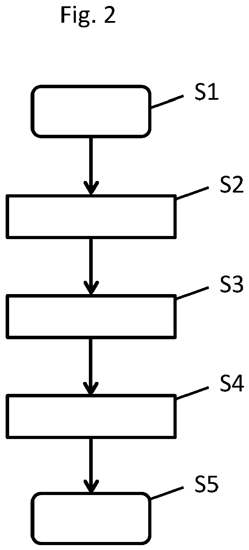

Figur 2 zeigt ein Ausführungsbeispiel eines computerimplementierten Verfahrens zur Optimierung einer Produktion eines Produkts als Ablaufdiagramm.

Das Verfahren umfasst folgende Verfahrensschritte:
In einem ersten Schritt S1 wird ein vorgegebener Produktionsparametersatz für die Produktion eingelesen. Dieser umfasst vorzugsweise einen Produktionsplan.

Als nächster Schritt S2 wird ein trainiertes Machine-Learning-Modell eingelesen. Das Machine-Learning-Modell wurde mittels Simulationsdaten darauf trainiert, in Abhängigkeit eines vorgegebenen Produktionsparametersatzes eine Kennzahl und eine Reihenfolge von Produktionsschritten auszugeben, wobei die Simulationsdaten durch eine Vielzahl von computergestützten Materialflusssimulationen auf Basis eines computergestützten Materialflussmodells der Produktion erfasst wurden, wobei für jede computergestützte Materialflusssimulation modifizierte Produktionsparametersätze angewandt wurden, und anhand jeder ausgeführten Materialflusssimulation eine Kennzahl und eine durchgeführte Reihenfolge der Produktionsschritte ermittelt wurde.

Als nächster Schritt S3 wird eine Kennzahl für die Produktion in Abhängigkeit des eingelesenen Produktionsparametersatzes mittels des trainierten Machine-Learning-Modells bestimmt. Anschließend, Schritt S4, wird der eingelesene Produktionsparametersatz derart modifiziert, dass diese Kennzahl optimiert wird. Für den modifizierten Produktionsparametersatz wird mittels des trainierten Machine-Learning-Modells eine entsprechende Reihenfolge der Produktionsschritte ermittelt.

Als nächster Schritt S5 wird der derart optimierte Produktionsparametersatz und die entsprechende Reihenfolge der Produktionsschritte ausgegeben. Anschließend kann die Produktion des Produkts gemäß dem optimierten Produktionsparametersatz gesteuert werden.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Vorrichtung (100) zur Optimierung einer Produktion eines Produkts, umfassend:
• eine erste Schnittstelle (101), die derart ein gerichtet ist, einen Produktionsparametersatz (PP) für die Produktion einzulesen,
• eine zweite Schnittstelle, (102) die derart eingerichtet ist, ein trainiertes Machine-Learning-Modell (ML) einzulesen,
∘ wobei das Machine-Learning-Modell (ML) mittels Simulationsdaten (SD) darauf trainiert ist, in Abhängigkeit eines vorgegebenen Produktionsparametersatzes eine Kennzahl und eine Reihenfolge von Produktionsschritten auszugeben,
∘ wobei die Simulationsdaten (SD) durch eine Vielzahl von computergestützten Materialflusssimulationen auf Basis eines computergestützten Materialflussmodells (SM) der Produktion erfasst werden, wobei für jede computergestützte Materialflusssimulation modifizierte Produktionsparametersätze angewandt werden, und anhand jeder ausgeführten Materialflusssimulation eine Kennzahl und eine Reihenfolge der Produktionsschritte ermittelt wird,
• ein Optimierungsmodul (103), das derart eingerichtet ist, für den eingelesenen Produktionsparametersatz (PP) eine Kennzahl mittels des trainierten Machine-Learning-Modells zu bestimmen, und den eingelesenen Produktionsparametersatz derart zu modifizieren, dass die Kennzahl optimiert wird, und für den derart modifizierten Produktionsparametersatz eine entsprechende Reihenfolge der Produktionsschritte mittels des trainierten Machine-Learning-Modells zu ermitteln, und
• ein Ausgabemodul (104), das derart eingerichtet ist, den derart optimierten Produktionsparametersatz (PP_opt) und die entsprechende Reihenfolge (R_opt) der Produktionsschritte auszugeben.

2. Vorrichtung (100) nach Anspruch 1, weiter umfassend einen Simulator (105), der derart eingerichtet ist,
• eine Vielzahl von computergestützten Materialflusssimulationen (SIM1, ..., SIMn) auf Basis eines computergestützten Materialflussmodells (SM) auszuführen, wobei für jede computergestützte Materialflusssimulation modifizierte Produktionsparametersätze (PP_mod1,..., PP_modn) angewandt werden,
• anhand jeder ausgeführten Materialflusssimulation eine Kennzahl und eine Reihenfolge der Produktionsschritte zu ermitteln,
und
• für jede Materialflusssimulation die Reihenfolge und die Kennzahl als Simulationsdaten (SD) sowie den entsprechenden modifizierten Produktionsparametersatz auszugeben.

3. Vorrichtung (100) nach Anspruch 1 oder 2, weiter umfassend ein Trainingsmodul (106), das derart eingerichtet ist, das Machine-Learning-Modell (ML) mittels der Simulationsdaten (SD) derart zu trainieren, in Abhängigkeit eines vorgegebenen Produktionsparametersatzes eine jeweils zugeordnete Kennzahl und Reihenfolge der Produktionsschritte zu reproduzieren.

4. Vorrichtung (100) nach Anspruch 3, wobei das Trainingsmodul (106) weiter eingerichtet ist, zusätzlich Betriebsdaten der Produktion für das Training des Machine-Learning-Modells zu berücksichtigen.

5. Vorrichtung (100) nach einem der vorhergehenden Ansprüche, wobei die Kennzahl
• einen Durchsatz der Produktion entsprechend der Produktionsparameter,
• eine zeitliche Dauer mindestens eines Produktionsschrittes,
und/oder
• gebundenes Kapital betrifft.

6. Vorrichtung (100) nach einem der vorhergehenden Ansprüche, wobei das computergestützte Materialflussmodell (SM)
• Arbeitsplätze und Verfügbarkeitsinformationen der Mitarbeiter der Produktion,
• räumliche Abstände zwischen Maschinen und/oder Material,
• Produktionsschritte der Produktion,
und/oder
• eine Aufteilung der Produktionsschritte auf Maschinen und/oder Mitarbeiter umfasst.

7. Vorrichtung (100) nach einem der vorhergehenden Ansprüche, wobei ein Produktionsparametersatz (PP) eine Regel zur Abarbeitung der Produktionsschritte umfasst.

8. Vorrichtung (100) nach einem der vorhergehenden Ansprüche, wobei das Ausgabemodul (104) weiter eingerichtet ist, auf Basis des optimierten Produktionsparametersatzes eine individuelle Reihenfolge von Produktionsschritten für einen Mitarbeiter auszugeben.

9. Computerimplementiertes Verfahren zur Optimierung einer Produktion eines Produkts, mit den Verfahrensschritten:
• Einlesen (S1) eines Produktionsparametersatzes für die Produktion,
• Einlesen (S2) eines trainierten Machine-Learning-Modells,
∘ wobei das Machine-Learning-Modell mittels Simulationsdaten darauf trainiert ist, in Abhängigkeit eines vorgegebenen Produktionsparametersatzes eine Kennzahl und eine Reihenfolge von Produktionsschritten auszugeben,
∘ wobei die Simulationsdaten durch eine Vielzahl von computergestützten Materialflusssimulationen auf Basis eines computergestützten Materialflussmodells der Produktion erfasst werden, wobei für jede computergestützte Materialflusssimulation modifizierte Produktionsparametersätze angewandt werden, und anhand jeder ausgeführten Materialflusssimulation eine Kennzahl und eine durchgeführte Reihenfolge der Produktionsschritte ermittelt wird,
• Bestimmen (S3) einer Kennzahl mittels des trainierten Machine-Learning-Modells für den eingelesenen Produktionsparametersatz,
• Modifizieren (S4) des eingelesenen Produktionsparametersatzes derart, dass die Kennzahl optimiert wird, und Ermitteln einer entsprechenden Reihenfolge der Produktionsschritte für den derart modifizierten Produktionsparametersatz mittels des trainierten Machine-Learning-Modells,
und
• Ausgeben (S5) des derart optimierten Produktionsparametersatzes und der entsprechenden Reihenfolge der Produktionsschritte.

10. Computerprogrammprodukt, das direkt in einen programmierbaren Computer ladbar ist, umfassend Programmcodeteile, die dazu geeignet sind, die Schritte des Verfahrens nach Anspruch 9 durchzuführen.
